# EUROPEAN PATENT SPECIFICATION

(11) **EP 4 553 814 B1**
(45) Date of publication and mention of the grant of the patent: **06.05.2026**
(21) Application number: 23860633.9
(22) Date of filing: 29.06.2023
(51) Int. Cl.: G09F 9/302, G09F 9/33, G06F 1/16, G06F 1/18, H05K 5/00, H05K 5/02, H05K 5/30

(54) **DISPLAY DEVICE**
ANZEIGEVORRICHTUNG
DISPOSITIF D'AFFICHAGE

(30) Priority: 02.09.2022 KR 20220111739
(43) Date of publication of application: 14.05.2025
(73) Proprietor: Samsung Electronics Co., Ltd., Suwon-si, Gyeonggi-do 16677 (KR)
(72) Inventor: KIM, Dowan, Suwon-si Gyeonggi-do 16677 (KR); KIM, Kiwoong, Suwon-si Gyeonggi-do 16677 (KR); KIM, Yoonah, Suwon-si Gyeonggi-do 16677 (KR); PARK, Chiun, Suwon-si Gyeonggi-do 16677 (KR); HWANG, Kwangsung, Suwon-si Gyeonggi-do 16677 (KR)
(74) Representative: Appleyard Lees IP LLP
(86) International application number: PCT/KR2023/009131
(87) International publication number: WO 2024/048950

(56) References cited:
- JP-A- 2017 211 400
- KR-A- 20170 050 736
- KR-A- 20190 009 235
- KR-A- 20210 037 964
- US-A1- 2007 000 849
- US-A1- 2009 225 506
- US-A1- 2017 357 472
- US-A1- 2020 029 436

## Description

### [TECHNICAL FIELD]

The disclosure relates to a display apparatus including a plurality of display modules and a cabinet supporting a plurality of display modules.

### [BACKGROUND ART]

A display apparatus converts acquired or stored electrical information into visual information and displays the converted information to a user.

A display apparatus may, in order to implement a large-sized screen, include a plurality of display modules and a cabinet supporting the plurality of display modules that are consecutively tiled in an upper to lower direction and a left to right direction. The cabinet supporting the plurality of display modules may be provided in plural, and the plurality of cabinets may also be provided to be consecutively tiled in an upper to lower direction and a left to right direction similar to the plurality of display modules. The plurality of display modules supported by the plurality of cabinets may form a single large screen.

JP 2017211400 A discloses a display apparatus including a plurality of display modules and a cabinet supporting the plurality of display modules.

### [DISCLOSURE]

### [TECHNICAL PROBLEM]

One aspect of the disclosure provides a display apparatus, according to claim 1, including a cabinet that is slim in a front-rear direction.

One aspect of the disclosure provides a seamless display apparatus with a reduced step between a plurality of cabinets in the front-rear, left-right, and upper-lower directions.

One aspect of the disclosure provides a display apparatus including a cabinet capable of being directly coupled to an external wall or a stand without a separate intermediary.

### [TECHNICAL SOLUTION]

A display apparatus according to an embodiment includes: a display module including a substrate on which a plurality of light-emitting diodes are mounted; a cabinet configured to support the display module such that the display module faces forward; and a circuit case coupled to the cabinet and configured to accommodate electrical components therein. The cabinet includes: a first frame configured to form an upper side of the cabinet and including a first adjustment hole having an assembly tolerance in a left-right direction, a second frame configured to form a lower side of the cabinet and including a second adjustment hole having an assembly tolerance in the left-right direction, a third frame configured to form a left side of the cabinet and including a third adjustment hole having an assembly tolerance in an upper-lower direction, and a fourth frame configured to form a right side of the cabinet and including a fourth adjustment hole having an assembly tolerance in the upper-lower direction.

### [ADVANTAGEOUS EFFECTS]

According to one aspect of the disclosure, a display apparatus including a cabinet that is slim in a front-rear direction can be provided.

According to one aspect of the disclosure, a seamless display apparatus with a reduced step between a plurality of cabinets in the front-rear, left-right, and upper-lower directions can be provided.

According to one aspect of the disclosure, a display apparatus including a cabinet capable of being directly coupled to an external wall or a stand without a separate intermediary can be provided.

### [DESCRIPTION OF DRAWINGS]

FIG. 1 is a view illustrating a display apparatus according to an embodiment.
FIG. 2 is a view illustrating a cabinet and a display module separated from the cabinet in a display apparatus according to an embodiment, when viewed from the front.
FIG. 3 is an enlarged view of portion A of FIG. 2.
FIG. 4 is a view illustrating a cabinet and a display module separated from the cabinet in a display apparatus according to an embodiment, when viewed from the rear.
FIG. 5 is a rear view of a display module in a display apparatus according to an embodiment.
FIG. 6 is a front view of a cabinet in a display apparatus according to an embodiment.
FIG. 7 is a view illustrating a cabinet separated from a display apparatus according to an embodiment.
FIG. 8 is an exploded view of the cabinet shown in FIG. 7.
FIG. 9 is a view for describing an assembly process of a cabinet in a display apparatus according to an embodiment.
FIG. 10 is an enlarged view of portion B of FIG. 7.
FIG. 11 is an exploded view illustrating components shown in FIG. 7.
FIG. 12 is an enlarged view of portion C of FIG. 7 at a different angle.
FIG. 13 is an exploded view illustrating components shown in FIG. 12.
FIG. 14 is an enlarged view of portions of a first cabinet and a second cabinet before being coupled to each other in a display apparatus according to an embodiment.
FIG. 15 is a view illustrating the appearance of the first cabinet and the second cabinet shown in FIG. 14 after being coupled to each other.
FIG. 16 is an enlarged view of portions of a first cabinet and a second cabinet before being coupled to each other in a display apparatus according to an embodiment.
FIG. 17 is a view illustrating the appearance of the first cabinet and the second cabinet shown in FIG. 16 after being coupled to each other.
FIG. 18 is a view illustrating portions of a first cabinet and a second cabinet arranged in an upper-lower direction in a display apparatus according to an embodiment.
FIG. 19 is an enlarged view of portion D of FIG. 18.
FIG. 20 is a view illustrating an example of a cabinet coupled to an external structure in a display apparatus according to an embodiment.
FIG. 21 is a view illustrating an example of a cabinet coupled to an external structure in a display apparatus according to an embodiment.

### [MODES OF THE DISCLOSURE]

Embodiments described in the specification and configurations shown in the accompanying drawings are merely examples of the disclosure, and various modifications may replace the embodiments and the drawings of the disclosure at the time of filing of the application.

Further, identical symbols or numbers in the drawings of the disclosure denote components or elements configured to perform substantially identical functions.

Further, terms used herein are only for the purpose of describing particular embodiments and are not intended to limit to the disclosure. The singular form is intended to include the plural form as well, unless the context clearly indicates otherwise. It should be further understood that the terms "include," "including," "have," and/or "having" specify the presence of stated features, integers, steps, operations, elements, components, and/or groups thereof, but do not preclude the presence or addition of one or more other features, integers, steps, operations, elements, components, and/or groups thereof.

Further, it should be understood that, although the terms "first," "second," etc. may be used herein to describe various elements, the elements are not restricted by the terms, and the terms are only used to distinguish one element from another. For example, a first element could be termed a second element, and similarly, a second element could be termed a first element without departing from the scope of the disclosure. The term "and/or" includes combinations of one or all of a plurality of associated listed items.

The terms "front", "rear", "left", "right", and the like as herein used are defined with respect to the drawings, but the terms may not restrict the shape and position of the respective components.

A display apparatus according to an embodiment includes: a display module including a substrate on which a plurality of light-emitting diodes are mounted; a cabinet configured to support the display module such that the display module faces forward; and a circuit case coupled to the cabinet and configured to accommodate electrical components therein, wherein the cabinet includes: a first frame configured to form an upper side of the cabinet and including a first adjustment hole having an assembly tolerance in a left-right direction, a second frame configured to form a lower side of the cabinet and including a second adjustment hole having an assembly tolerance in the left-right direction, a third frame configured to form a left side of the cabinet and including a third adjustment hole having an assembly tolerance in an upper-lower direction, and a fourth frame configured to form a right side of the cabinet and including a fourth adjustment hole having an assembly tolerance in the upper-lower direction.

The cabinet may include a first cabinet and a second cabinet coupled to the first cabinet in the upper-lower direction.

The first cabinet and the second cabinet may allow seam-adjustment in the left-right direction within a range in which the first adjustment hole of the first cabinet and the second adjustment hole of the second cabinet may overlap in the upper-lower direction.

The cabinet may include a first cabinet and a second cabinet coupled to the first cabinet in the left-right direction.

The first cabinet and the second cabinet may allow seam adjustment in the upper-lower direction within a range in which the third adjustment hole of the first cabinet and the fourth adjustment hole of the second cabinet may overlap in the left-right direction.

The first frame may further include a coupling protrusion protruding upward from an upper surface of the first frame.

The second frame may further include a coupling groove recessed upward from a lower surface of the second frame and configured to accommodate the coupling protrusion.

A width of the coupling groove in a front-rear direction and a thickness of the coupling protrusion in the front-rear direction may be provided without an assembly tolerance to prevent the coupling protrusion from moving in the front-rear direction within the coupling groove.

The cabinet may include a first cabinet and a second cabinet coupled to the first cabinet in the upper-lower direction.

The first cabinet and the second cabinet may be seamless in the front-rear direction with the coupling protrusion being inserted into the coupling groove.

The cabinet may further include a first upper corner bracket configured to couple the first frame and the third frame, and a second upper corner bracket configured to connect the first frame and the fourth frame.

The first upper corner bracket may include a fifth adjustment hole having a size and shape corresponding to the first adjustment hole, and a sixth adjustment hole having a size and shape corresponding to the third adjustment hole.

The second upper corner bracket may include a seventh adjustment hole having a size and shape corresponding to the first adjustment hole, and an eighth adjustment hole having a size and shape corresponding to the fourth adjustment hole.

The cabinet may further include a first lower corner bracket configured to couple the second frame and the third frame and a second lower corner bracket configured to couple the second frame and the fourth frame.

The first lower corner bracket may include a fifth adjustment hole having a size and shape corresponding to the second adjustment hole, and a sixth adjustment hole having a size and shape corresponding to the third adjustment hole.

The second lower corner bracket may include a seventh adjustment hole having a size and shape corresponding to the second adjustment hole, and an eighth adjustment hole having a size and shape corresponding to the fourth adjustment hole.

Each of the first upper corner bracket and the second upper corner bracket may further include a horizontal support portion configured to be coupled to a horizontal surface of an external structure.

Each of the first upper corner bracket and the second upper corner bracket may further include a vertical support portion configured to be coupled to a vertical surface of an external structure.

An upper end of the third frame may be configured to support one side end of the first frame.

An upper end of the fourth frame may be configured to support the other side end of the first frame.

The first frame to the fourth frame may be formed by extrusion molding a metal material.

The display module may include a plurality of display modules, and the cabinet may be configured to support the plurality of display modules.

Hereinafter, embodiments according to the disclosure will be described in detail with reference to the accompanying drawings.

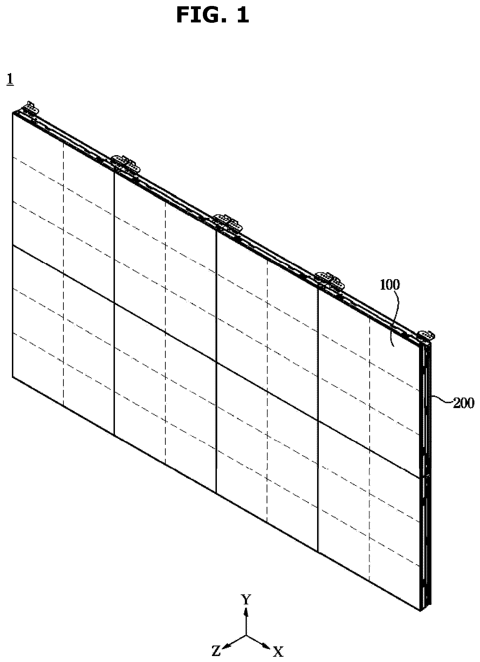

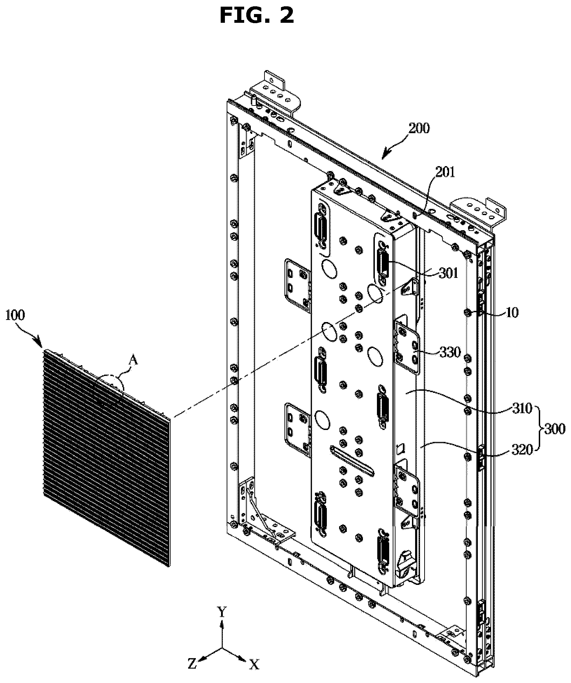

FIG. 1 is a view illustrating a display apparatus according to an embodiment. FIG. 2 is a view illustrating a cabinet and a display module separated from the cabinet in a display apparatus according to an embodiment, which is viewed from the front.

In FIG. 1, the X-axis, the Y-axis, and the Z-axis directions perpendicular to each other are shown, in which the X-axis direction refers to a left to right direction, the Y-axis direction refers to an upper to lower direction, and the Z-axis direction refers to a front to rear direction.

The following description is made with reference to FIGS. 1 and 2. A display apparatus 1 is a device that displays information, materials, data, and the like in the form of characters, figures, graphs, images, and the like, and may be implemented as a billboard, an electric sign board, a screen, a television, a monitor, and the like. The display apparatus 1 may be installed on a wall or ceiling, or installed on an indoor or outdoor ground by a stand.

The display apparatus 1 may include a display module 100 displaying a screen, a cabinet 200 coupled to a rear side of the display module 100 to support the display module 100, and a circuit case 300 coupled to the cabinet 200 and accommodating electronic components therein.

In the display apparatus 1 according to an embodiment, six display modules 100 may be coupled to one cabinet 200. Specifically, two of the display modules 100 may be coupled to the one cabinet 200 in a left to right direction X, and three of the display modules 100 may be coupled to the one cabinet 200 in a upper to lower direction Y. That is, the display modules 100 may be coupled to the cabinet 200 in a 2 x 3 matrix form. However, the number of display modules 100 coupled to the cabinet 200 is not limited. Two or more display modules 100 may be coupled to one cabinet 200.

Referring to FIG. 1, the display apparatus 1 according to the embodiment may include eight cabinets 200 and forty eight display modules 100 coupled to the eight cabinets 200. As described above, the display apparatus 1 may implement a large sized screen by consecutively arranging a plurality of cabinets 200, to which a plurality of display modules 100 are coupled, in the left to right direction X and the upper to lower upper to lower direction Y. The number of cabinets 200 consecutively arranged in the left to right direction X and in the upper to lower direction Y is not limited, and as described above, the number of the plurality of display modules 100 coupled to the cabinet 200 is not limited.

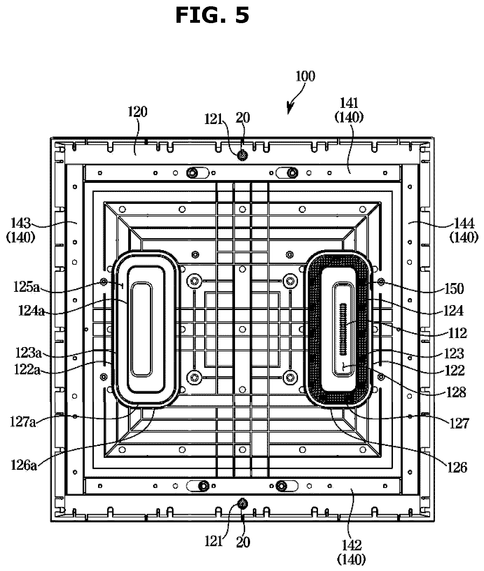

Referring to FIG. 2, the display module 100 may be separably coupled to the cabinet 200. The display module 100 may be separated from the cabinet 200 forward of the cabinet 200. The display module 100 may be coupled to the cabinet 200 by magnetic force. The cabinet 200 may include a plurality of first magnets 10 provided on the front surface of the cabinet 200. The circuit case 300 may a plurality of second magnets 10 provided on the front surface of the circuit case 300. The display module 100 may include a reinforcement member (140, see FIG. 5) provided on a rear surface thereof and coupled to the plurality of first magnets 10 and the plurality of second magnets 10 by magnetic attraction. The plurality of first magnets 10 provided on the cabinet 200 and the plurality of second magnets 10 provided on the circuit case 300 may be the same components. The plurality of first magnets 10 and the plurality of second magnets 10 may be collectively referred to as the plurality of magnets 10.

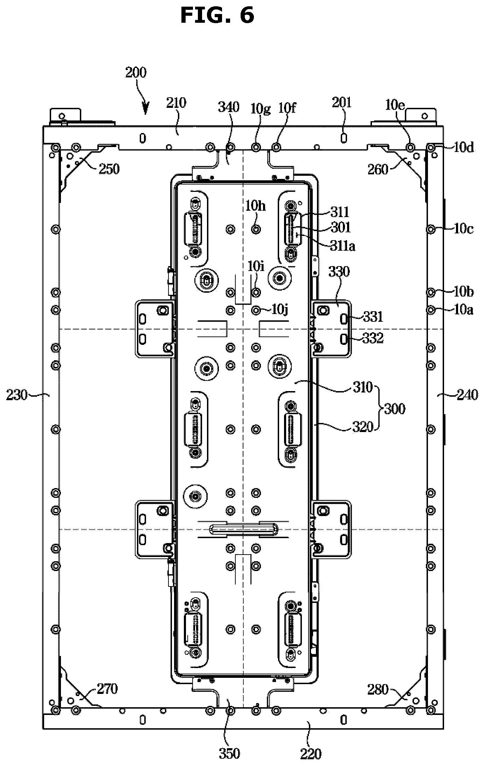

The cabinet 200 may include frames (210, 220, 230, and 240, see FIG. 6) forming an outer edge of the cabinet 200. The circuit case 300 may be disposed inside of the frames 210, 220, 230, and 240. The circuit case 300 may include a second connector 301 corresponding to a first connector (112, see FIG. 5) included in each of the plurality of display modules 100. The circuit case 300 may include a first case 310 having a hexahedral shape with one surface open and a second case 320 provided to cover the open surface of the first case 310.

As the first connectors 112 of the plurality of display modules 100 are coupled to the second connectors 301 of the circuit case 300, the plurality of display modules 100 may be electrically connected to each other. In addition, the plurality of display modules 100 may be supplied with power from a power supply device disposed inside the circuit case 300.

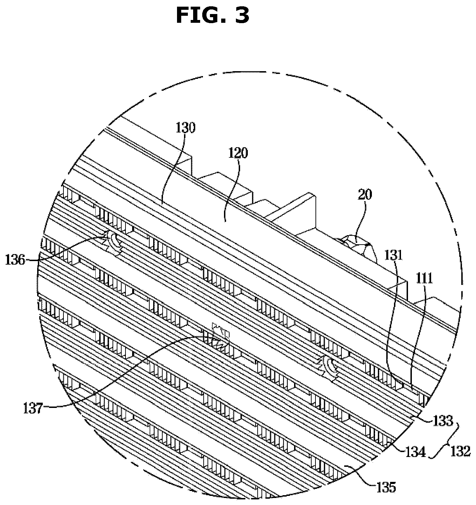

FIG. 3 is an enlarged view of portion A of FIG. 2.

Referring to FIG. 3, the display module 100 may include a substrate (not shown) and a holder 120 covering side and rear surfaces of the substrate and supporting the substrate. The substrate may be attached to a front surface of the holder 120 through an adhesive, a double-sided adhesive tape, or the like, or coupled to the holder 120 through a fastening member, such as a screw.

A plurality of light-emitting diodes (LEDs) 111 may be mounted on the front surface of the substrate. The substrate may be formed of a material, such as glass, polyimide (PI), or FR4.

The plurality of LEDs 111 may include a red LED, a green LED, and a blue LED as one pixel in a package. A plurality of LEDs 111 may be mounted on the substrate in a matrix form. The plurality of LEDs 111 may be arranged to have regular intervals, and intervals between the plurality of LEDs 111 may be variously determined according to the resolution and size of the display apparatus 1.

The display module 100 may include a cover plate 130 provided to cover the front surface of the substrate. The cover plate 130 may include a plurality of LED holes 131 respectively corresponding to the plurality of LEDs 111 mounted on the substrate. The plurality of LEDs 111 may be exposed on the front surface of the cover plate 130 through the plurality of LED holes 131.

The substrate may be accommodated inside of the cover plate 130 and the holder 120. The cover plate 130 and the holder 120 may be coupled to each other to form an inner space accommodating the substrate therein.

The cover plate 130 may include a louver portion 132. The louver portion 132 may include a horizontal louver portion 133 and a vertical louver portion 134. The louver portion 132 may reduce or block moisture flowing into the plurality of LEDs 111. In addition, the cover plate 130 may include a loop portion 135 provided on upper sides of the plurality of LEDs 111. The loop portion 135 may protrude forward of the cover plate 130 to prevent water from being directly introduced into the plurality of LEDs 111 from above.

The cover plate 130 may include a fastening hole 136 into which a fastening member (not shown) for coupling the cover plate 130, the substrate, and the holder 120 is inserted, and a fixing hole 137 into which a fixing member 20 is inserted.

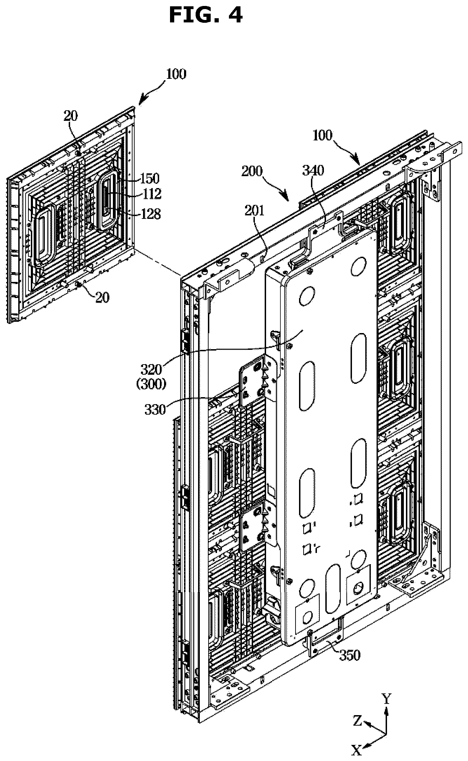

FIG. 4 is a view illustrating a cabinet and a display module separated from the cabinet in a display apparatus according to an embodiment, which is viewed from the rear.

FIG. 5 is a rear view illustrating a display module in a display apparatus according to an embodiment.

Referring to FIG. 4, the display module 100 may be separated forward of the cabinet 200. As described above, the display module 100 may be coupled to the cabinet 200 by magnetic force. A plurality of magnets (10, see FIG. 2) may be provided on the front surface of the cabinet 200, and a reinforcement member (140, see FIG. 5) attracted by magnetic attraction of the plurality of magnets 10) may be provided on the rear surface of the display module 100.

Referring to FIG. 5, the reinforcement member 140 may be coupled to the rear surface of the holder 120. The reinforcement member 140 may be disposed on an edge of the rear surface of the holder 120. The reinforcement member 140 may include a first reinforcement member 141, a second reinforcement member 142, a third reinforcement member 143, and a fourth reinforcement member 144. The first reinforcement member 141 may be provided adj acent to an upper edge of the rear surface of the holder 120 and may extend in the horizontal direction. The second reinforcement member 142 may be provided adjacent to a lower edge of the rear surface of the holder 120 and may extend in the horizontal direction. The third reinforcement member 143 may be provided adjacent to a left edge of the rear surface of the holder 120 and may extend in the vertical direction. The fourth reinforcement member 144 may be provided adjacent to a right edge of the rear surface of the holder 120 and may extend in the vertical direction.

The reinforcement member 140 may be coupled to the rear surface of the holder 120 to reinforce the strength of the display module 100. The reinforcement member 140 may prevent the display module 100 from bending. The reinforcement member 140 may prevent physical deformation of the display module 100.

The reinforcement member 140 may be formed of a material that is attracted by the magnetic force of the magnet 10. The reinforcement member 140 may be formed of a material that is magnetizble by an external magnetic force. The reinforcement member 140 and the magnet 10 may be attracted to each other by polarity of the reinforcement member 140 obtained from the external magnetic force. The reinforcement member 140 may include a magnetic material that interacts with the magnet 10. The reinforcement member 140 may include iron (Fe).

The display module 100 may include a fixing member 20. The fixing members 20 may pass through a holder hole 121 of a holder 120 to protrude rearward of the display module 100. According to one embodiment, the fixing members 20 may be provided at the upper center region of the rear surface and the lower center region of the rear surface of the display module 100, but the positions thereof are not limited.

The fixing member 20 may prevent the display module 100 from being separated from the cabinet 200. The display module 100 may be coupled by a magnetic attraction between the plurality of magnets 10 and the reinforcement member 140, but in response to application of a force greater than the magnetic attraction to separate the display module 100 from the cabinet 200, the display module 100 may be separated from the cabinet 200. In order to prevent the separation, the fixing member 20 may be provided to prevent the display module 100 from moving forward of the cabinet 200.

The display module 100 may include a first connector hole 128 that allows the first connector 112 provided on the rear surface of the substrate to be exposed on the rear surface of the display module 100. The display module 100 may include a first waterproof rib 122, a second waterproof rib 123, and a third waterproof rib 124 protruding rearward from the rear surface of the holder 120 to block water from being introduced into the first connector hole 128. A sealing groove may be formed between the second waterproof rib 123 and the third waterproof rib 124, and a sealing member 150 may be provided in the sealing groove. A first drain hole 126 may be formed at a lower end of the first waterproof rib 122, and a second drain hole 127 may be formed at a lower end of the second waterproof rib 123.

The first waterproof rib 122, the second waterproof rib 123, and the third waterproof rib 124 may each be provided in a ring shape. The second waterproof rib 123 may be provided inside of the first waterproof rib 122, and the third waterproof rib 124 may be provided inside of the second waterproof rib 123.

The first to third waterproof ribs 122, 123, and 124 may be provided to be in contact with the front surface of the circuit case 300 to prevent moisture from being introduced from the outer side to the inside of the first to third waterproof ribs 122, 123, and 124.

The sealing member 150 may be provided in the sealing groove formed between the second waterproof rib 123 and the third waterproof rib 124. The sealing member 150 may be provided to correspond to the shape of the sealing groove . The sealing member 150 may be provided in a substantially ring shape. The sealing member 150 may be formed of a material capable of changing in volume, and may include, for example, rubber.

According to an embodiment, the sealing member 150 may be attached to the rear surface of the display module 100, but is not limited thereto. The sealing member 150 may be attached to the front surface of the circuit case 300 to correspond to the sealing groove

The display module 100 may include a first waterproof rib 122a, a second waterproof rib 123a, a third waterproof rib 124a, and a sealing groove 125a bilaterally symmetrical to the first waterproof rib 122, the second waterproof rib 123, the third waterproof rib 124, and the sealing groove . For the sake of convenience of description, the first to third waterproof ribs 122a, 123a, and 124a may be referred to as left side waterproof ribs, and the first to third waterproof ribs 122, 123, and 124 may be referred to as right side waterproof ribs.

The left side waterproof ribs 122a, 123a, and 124a may have the same structures bilaterally symmetrical to those of the right side waterproof ribs 122, 123, and 124. This is to allow the display modules 100 to be coupled to both a left column and a right column among two columns of the cabinet 200. For example, when the display module 100 is coupled to the right column of the cabinet 200, the first connector 112 may be disposed inside of the right side waterproof ribs 122, 123, and 124, and the sealing member 150 may be provided in the right side sealing groove to prevent water from being introduced into the first connector 112. Conversely, when the display module 100 is coupled to the left column of the cabinet 200, the first connector 112 may be disposed inside of the left side waterproof ribs 122a, 123a, and 124a, and the sealing member 150 may be provided in the left side sealing groove a. In addition, the first connector hole may not be provided inside of a waterproof rib in which the first connector 112 is not disposed. Referring to FIG. 5, a first connector hole may not be provided inside of the left side third waterproof rib 124a, and a first connector hole 128 may be provided inside of the right side third waterproof rib 124 to allow the first connector 112 to be exposed therethrough.

FIG. 6 is a front view illustrating a cabinet in a display apparatus according to an embodiment.

The cabinet 200 may be formed by coupling four frames 210, 220, 230, and 240 each extending in one direction. The four frames 210, 220, 230, and 240 may be coupled to each other by four corner brackets 250, 260, 270, and 280.

Specifically, the frames 210, 220, 230, and 240 may include a first frame 210 forming an upper edge of the cabinet 200, a second frame 220 forming a lower edge of the cabinet 200, a third frame 230 forming a left edge of the cabinet 200, and a fourth frame 240 forming a right edge of the cabinet 200. The first frame 210 and the second frame 220 may be disposed in the horizontal direction, and the third frame 230 and the fourth frame 240 may be disposed in the vertical direction.

The first frame 210 and the third frame 230 may be coupled by a first upper corner bracket 250. The first frame 210 and the fourth frame 240 may be coupled to each other by a second upper corner bracket 260. The second frame 220 and the third frame 230 may be coupled to each other by a first lower corner bracket 270, and the second frame 220 and the fourth frame 240 may be coupled to each other by a second lower corner bracket 280.

The circuit case 300 may be located at the central region inside of the frames 210, 220, 230, and 240. The circuit case 300 may be coupled to the frames 210 and 220 by a first connection bracket 340 and a second connection bracket 350 respectively provided on the upper side and the lower side of the circuit case 300.

The circuit case 300 may include a first case 310 forming front and side surfaces of the circuit case 300 and having a rear surface thereof open, and a second case 320 provided to cover the open rear surface of the first case 310. The first case 310 and the second case 320 may be coupled to each other to form the circuit case 300. The first case 310 and the second case 320 may be coupled to each other such that an inside of the first case 310 and the second case 320 may be sealed. The first case 310 and the second case 320 may be coupled to each other to block inflow of water from the outside.

The first case 310 may have a second connector hole 311a formed through the front surface thereof. The first case 310 may include a rib 311 provided along the circumference of the second connector hole 311a and protruding forward. A second connector 301 may be disposed inside of the second connector hole 311a.

The second connector hole 311a, the second connector 301, and the rib 311 may be provided corresponding in number to the number of display modules 100 coupled to the cabinet 200.

Inside the circuit case 300, provided may be a power supply device (not shown) provided to supply power to the display module 100, a control board (not shown) provided to control the display module 100, and the like. In this specification, electronic parts may include the power supply device and the control board described above.

The circuit case 300 may include a support bracket 330 provided to support the display module 100. The support brackets 330 may be coupled to both sides of the circuit case 300. In addition, the support brackets 330 may be provided above and below each other, on both sides of the circuit case 300. According to an embodiment, four support brackets 330 may be coupled to the circuit case 300.

The cabinet 200 may include a plurality of magnets 10. In addition, the circuit case 300 may include a plurality of magnets 10.

Specifically, the cabinet 200 may include a plurality of magnets 10 disposed spaced apart from each other on the front surfaces of the first to fourth frames 210, 220, 230, and 240.

In addition, the circuit case 300 may include a plurality of magnets 10 disposed spaced apart from each other on the front surface of the circuit case 300.

Referring to FIG. 6, the cabinet 200 and the circuit case 300 according to the embodiment may include ten magnets 10 for each of the display module 100. The cabinet 200 and the circuit case 300 may include a total of sixty magnets 10. The cabinet 200 may include thirty eight magnets 10, and the circuit case 300 may include twenty two magnets 10. However, the number and position of the magnets 10 are not limited thereto, and the number and position of the magnets 10 may be changed.

For example, in order to support the display module 100 coupled to the upper right side of the cabinet 200, the cabinet 200 may include the first to seventh magnets 10a, 10b, 10c, 10d, 10e, 10f, and 10g, and the circuit case 300 may include the eighth to tenth magnets 10h, 10i, and 10j.

As described above, the plurality of magnets 10 may attract the reinforcement member 140, which is formed of a magnetizable material and disposed on the rear surface of the display module 100, by magnetic attraction, such that the display module 100 may be coupled to the cabinet 200.

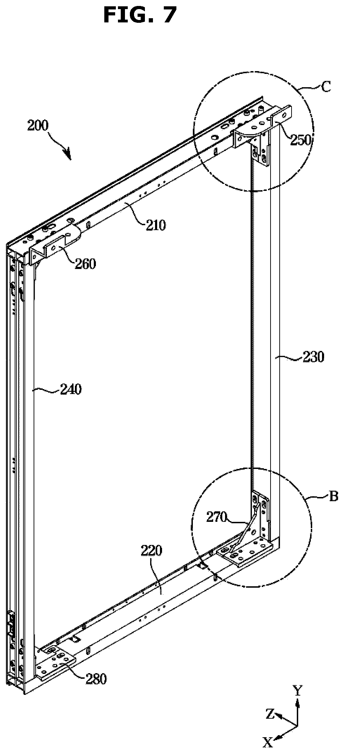

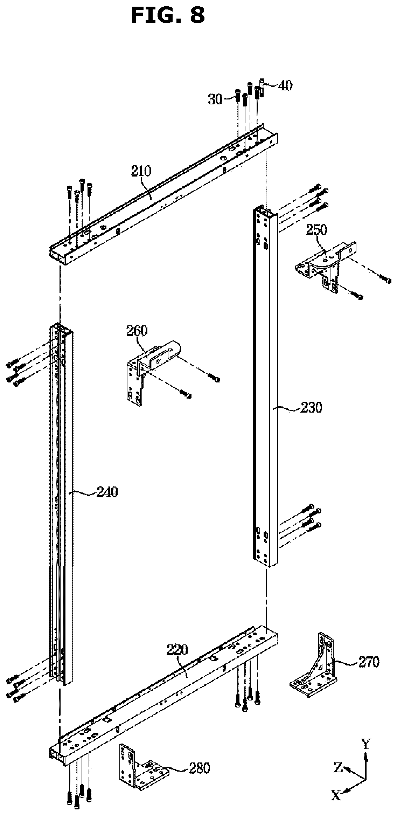

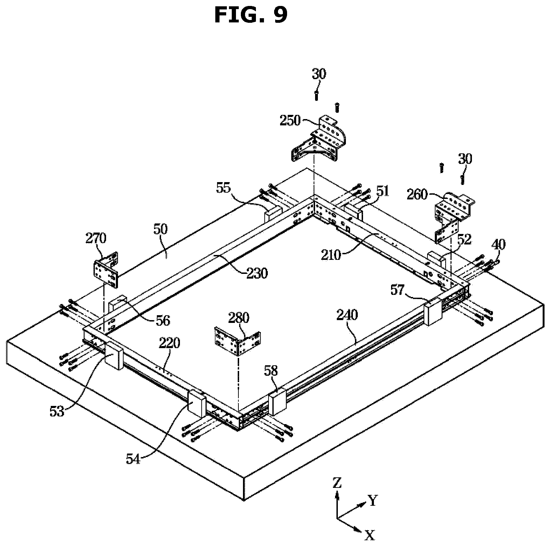

FIG. 7 is a view illustrating a cabinet separated from a display apparatus according to an embodiment. FIG. 8 is an exploded view of the cabinet shown in FIG. 7. FIG. 9 is a view for describing an assembly process of a cabinet in a display apparatus according to an embodiment.

Referring to FIGS. 7 to 9, an assembly process of the cabinet 200 will be described.

As described above, the cabinet 200 may be prepared by coupling the first to fourth frames 210, 220, 230, and 240. The first to fourth frames 210, 220, 230, and 240 may each be formed by extruding a raw material formed of metal. The first to fourth frames 210, 220, 230, and 240 may be prepared in an approximately rectangular prism shape with an empty interior. The first to fourth frames 210, 220, 230, and 240 may be provided with support ribs inside thereof, configured to connect two inner surfaces facing each other. In particular, in order to increase the maximum load in the upper-lower direction Y, the support ribs may be provided inside the first frame 210 and the second frame 220.

The first frame 210 may include a support rib extending in the upper-lower direction Y. In the empty internal space of the first frame 210, the support rib may be provided to support an inner upper surface and an inner lower surface of the first frame 210 at the center. The support ribs may increase the maximum load of the first frame 210 in the upper-lower direction Y.

The second frame 220 may include a support rib extending in the upper-lower direction Y. In the empty internal space of the second frame 220, the support rib may be provided to support an inner upper surface and an inner lower surface of the second frame 220 at the center. The support rib may increase the maximum load in the upper-lower direction Y of the second frame 220.

The third frame 230 may be coupled to a lower surface of one side end of the first frame 210. Similarly, the fourth frame 240 may be coupled to a lower surface of the other side end of the first frame 210. In other words, an upper surface of the third frame 230 may be provided to support the lower surface of the first frame 210, and an upper surface of the fourth frame 240 may be provided to support the lower surface of the first frame 210.

When a side surface of the first frame 210 is coupled to a side surface of the third frame 230, the maximum load in the upper-lower direction Y that the cabinet 200 may support may be reduced.

Since the third frame 230 and the fourth frame 240 are coupled to the first frame 210 to have the upper surfaces thereof support the lower surface of the first frame 210, the maximum load in the upper-lower direction Y that the cabinet 200 may support may be maximized.

The cabinet 200 may include corner brackets 250, 260, 270, and 280 formed by die casting a metal material. The corner brackets 250, 260, 270, and 280 may be provided to connect two frames that meet each other vertically.

The cabinet 200 may include a first upper corner bracket 250 that couples the first frame 210 and the third frame 230. Since a second upper corner bracket 260 that couples the first frame 210 and the fourth frame 240 has a structure that is symmetrical to the first upper corner bracket 250, only the first upper corner bracket 250 will be described below. **In** addition, the first upper corner bracket 250 may be referred to as an upper corner bracket 250.

The cabinet 200 may include a first lower corner bracket 270 that couples the second frame 220 and the third frame 230. Since a second lower corner bracket 280 that couples the second frame 220 and the fourth frame 240 has a structure that is symmetrical to the first lower corner bracket 270, only the first lower corner bracket 270 will be described below. In addition, the first lower corner bracket 270 may be referred to as a lower corner bracket 270.

Referring to FIG. 9, a jig 50 may be used to assemble the cabinet 200. The jig 50 may reduce the assembly tolerance of the cabinet 200.

The jig 50 may include a plate portion on which the first to fourth frames 210, 220, 230, and 240 are placed, and a plurality of jig protrusions 51, 52, 53, 54, 55, 56, 57, and 58 protruding upward from the plate portion.

The first jig protrusion 51 and the second jig protrusion 52 may guide the position of the first frame 210. The third jig protrusion 53 and the fourth jig protrusion 54 may guide the position of the second frame 220. The fifth jig protrusion 55 and the sixth jig protrusion 56 may guide the position of the third frame 230. The seventh jig protrusion 57 and the eighth jig protrusion 58 may guide the position of the fourth frame 240.

After positioning the first to fourth frames 240 to be in contact with the plurality of jig protrusions 51 to 58, four corner brackets 250, 260, 270, and 280 are fastened to the first to fourth frames 240 and thus the cabinet 200 may be assembled. In this case, the corner bracket and the frame may be coupled by a fastening member 30. The fastening member 30 may include a screw.

The jig 50 may reduce the assembly tolerance by guiding and fixing the positions of the first to fourth frames 210, 220, 230, and 240 when coupling the corner brackets 250, 260, 270, and 280 to the first to fourth frames 210, 220, 230, and 240.

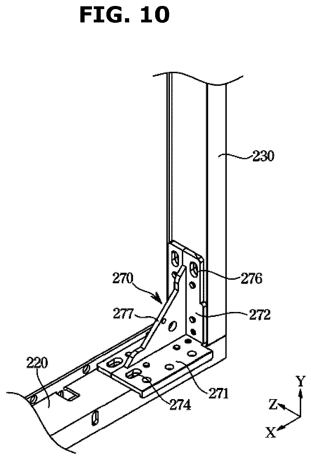

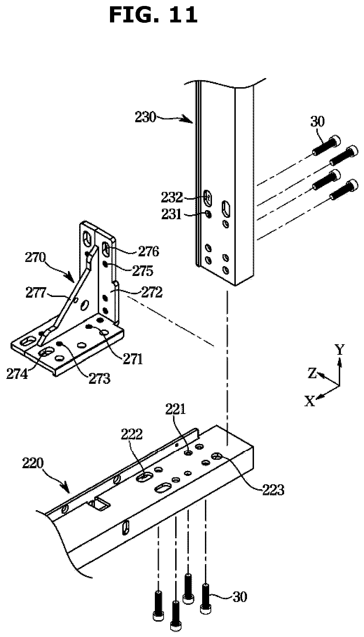

FIG. 10 is an enlarged view of portion B of FIG. 7. FIG. 11 is an exploded view illustrating components shown in FIG. 7.

Referring to FIGS. 10 and 11, the lower corner bracket 270 may be provided to couple the second frame 220 and the third frame 230.

The lower corner bracket 270 may include a horizontal plate portion 271 provided to be coupled with the second frame 220, a vertical plate portion 272 provided to be coupled with the third frame 230, and a connecting rib 277 reinforcing the strength of the lower corner bracket 270 by connecting the horizontal plate portion 271 and the vertical plate portion 272.

The horizontal plate portion 271 may include a fastening hole 273 provided for the fastening member 30 to pass therethrough, and an adjustment hole 274 provided to adjust a seam in the left-right direction X between the cabinets 200.

The vertical plate portion 272 may extend vertically from one end of the horizontal plate portion 271. The vertical plate portion 272 may include a fastening hole 275 provided for the fastening member 30 to pass therethrough, and an adjustment hole 276 provided to adjust a seam in the upper-lower direction Y between the cabinets 200.

The second frame 220 may include a fastening hole 221 provided for the fastening member 30 to pass therethrough and corresponding to the fastening hole 273 of the horizontal plate portion 271, and an adjustment hole 222 provided at a position corresponding to the adjustment hole 274 of the horizontal plate portion 271 and having a size and shape corresponding to the adjustment hole 274. The second frame 220 may further include a position guide hole 223 provided for a position guide member 40 to be inserted thereinto.

The third frame 230 may include a fastening hole 231 provided for the fastening member 30 to pass therethrough and corresponding to the fastening hole 275 of the vertical plate portion 272, and an adjustment hole 232 provided at a position corresponding to the adjustment hole 276 of the vertical plate portion 272 and having a size and shape corresponding to the adjustment hole 276.

The second frame 220 and the third frame 230 may be coupled by positioning the lower corner bracket 270 such that the fastening holes 273 and 275 of the lower corner bracket correspond to the fastening holes 221 and 231 of the second frame and the third frame, and then fastening the fastening member 30.

The second frame 220 and the fourth frame 240 may be coupled in the same manner as the second frame 220 and the third frame 230 are coupled.

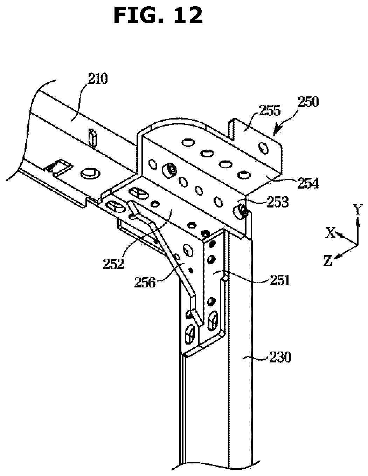

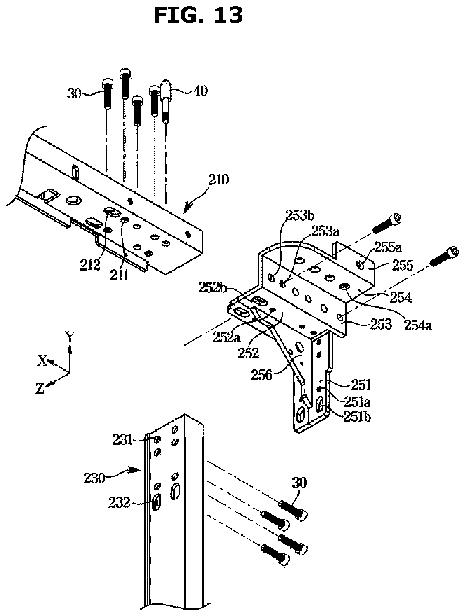

FIG. 12 is an enlarged view of portion C of FIG. 7 in a different angle. FIG. 13 is an exploded view illustrating components shown in FIG. 12.

Referring to FIG. 12 and FIG. 13, the upper corner bracket 250 may be provided to couple the first frame 210 and the third frame 230.

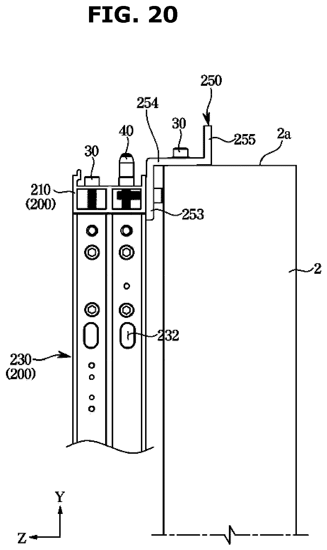

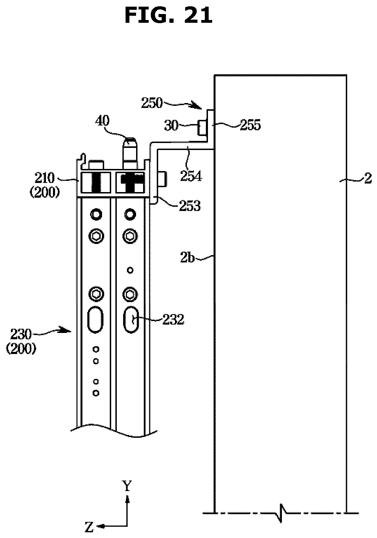

The upper corner bracket 250 may include a horizontal plate portion 252 provided to couple with the first frame 210, a vertical plate portion 251 provided to couple with the third frame 230, a rear coupling portion 253 provided to couple with a rear surface of the first frame 210, a horizontal support portion 254 provided to couple with a horizontal surface 2a of an external structure 2, see FIG. 20, and a vertical support portion 255 provided to couple with a vertical surface 2b of the external structure 2, see FIG. 21. In addition, the upper corner bracket 250 may include a connecting rib 256 that reinforces the strength of the upper corner bracket 250 by connecting the horizontal plate portion 252 and the vertical plate portion 251.

The horizontal plate portion 252 may include a fastening hole 252a provided for the fastening member 30 to pass through, and an adjustment hole 252b provided to adjust the seam in the left-right direction X between the cabinets 200.

The vertical plate portion 251 may extend vertically from one end of the horizontal plate portion 252. The vertical plate portion 251 may include a fastening hole 251a provided for the fastening member 30 to pass therethrough, and an adjustment hole 251b provided for adjusting the seam in the upper-lower direction Y between the cabinets 200.

The rear coupling portion 253 may include fastening holes 253a and 253b corresponding to a fastening hole provided on the rear surface of the first frame 210.

The horizontal support portion 254 may include a plurality of fastening holes 254a. The vertical support portion 255 may include a fastening hole 255a.

The first frame 220 may include a fastening hole 211 provided for the fastening member 30 to pass therethrough and corresponding to the fastening hole 252a of the horizontal plate portion 252, and an adjustment hole 212 provided at a position corresponding to the adjustment hole 252b of the horizontal plate portion 252 and having a size and shape corresponding to the adjustment hole 252b. The first frame 210 may further include a position guide hole (not shown) provided for the position guide member 40 to be inserted thereinto.

The third frame 230 may include a fastening hole 231 provided for the fastening member 30 to pass therethrough and corresponding to the fastening hole 251a of the vertical plate portion 251, and an adjustment hole 232 provided at a position corresponding to the adjustment hole 251b of the vertical plate portion 251 and having a size and shape corresponding to the adjustment hole 251b.

The first frame 210 and the third frame 230 may be coupled by positioning the upper corner bracket 250 such that the fastening holes 251a and 252a of the upper corner bracket correspond to the fastening holes 211 and 231 of the first frame and the third frame, and then fastening the fastening member 30.

The first frame 210 and the fourth frame 240 may be coupled in the same manner as the first frame 210 and the third frame 230 are coupled.

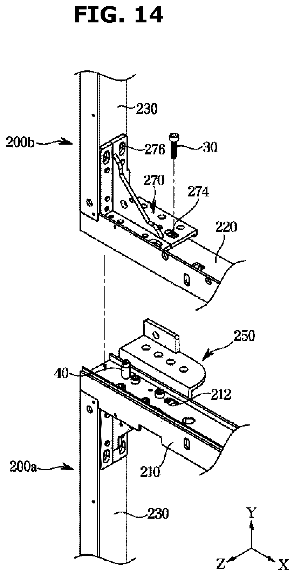

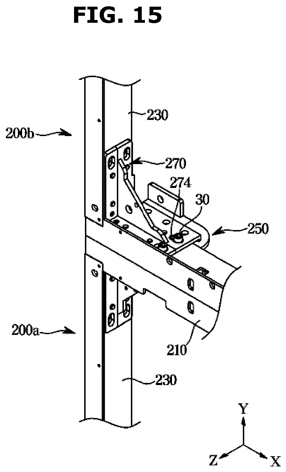

FIG. 14 is an enlarged view of portions of a first cabinet and a second cabinet before being coupled to each other in a display apparatus according to an embodiment. FIG. 15 is a view illustrating the appearance of the first cabinet and the second cabinet shown in FIG. 14 after being coupled to each other.

Referring to FIGS. 14 and 15, a method of removing a seam in the left-right direction X between cabinets 200a and 200b will be described.

Referring to FIG. 14, the first frame 210 and the second frame 220 may include adjustment holes 212 and 222, respectively, for adjusting the seam in the left-right direction X. The adjustment holes 212 and 222 may each have an extra length in the left-right direction X for adjusting the seam in the left-right direction X. That is, the length of the left-right direction X of the adjustment holes 212 and 222 may be provided longer than the length of the front-rear direction Z of the adjustment holes 212 and 222. In other words, the adjustment holes 212 and 222 may be provided without a tolerance in the front-rear direction Z while having a tolerance in the left-right direction X.

Due to the characteristics of extrusion molding and punching, the fastening holes and adjustment holes formed in the frames 210, 220, 230, and 240 may be formed at predetermined positions without substantial error. However, a tolerance may occur during the process of cutting or assembling the frames 210, 220, 230, and 240, which may result in a seam in the left-right direction X, upper-lower direction Y, and front-rear direction Z.

In the first cabinet 200a and the second cabinet 200b that are connected in the upper-lower direction, the first cabinet 200a and the second cabinet 200b may be positioned such that one ends (for example, the left ends of FIG. 15 of the first cabinet 200a and the second cabinet 200b form a straight line to prevent a seam in the left-right direction X from occurring.

Even when the first cabinet 200a and the second cabinet 200b are positioned such that there is no step in the left-right direction X, the adjustment holes 212 and 252b of the first cabinet 200a may be spaced apart from the adjustment holes 222 and 274 of the second cabinet 200bin the left-right direction X due to the assembly tolerance and the tolerance that occurs when cutting the frame. As described above, since the adjustment holes 212, 252b, 222, and 274 have an extra length in the left-right direction X, the adjustment holes 212and 252b of the first cabinet 200a and the adjustment holes 222 and 274 of the second cabinet 200b may be coupled by the fastening member 30 even when spaced apart from each other in the left-right direction X. Such a structure may prevent a step in the left-right direction X from occurring when the first cabinet 200a and the second cabinet 200b are coupled. In other words, seamlessness in the left-right direction X may be implemented.

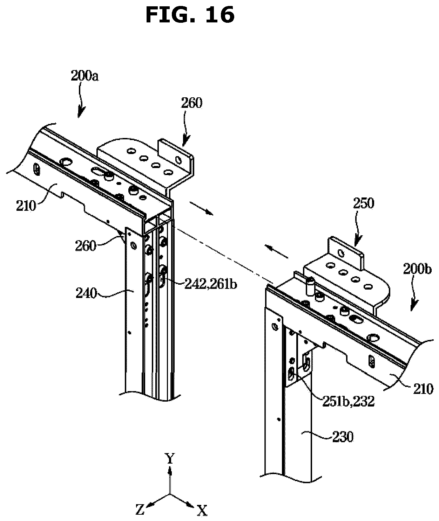

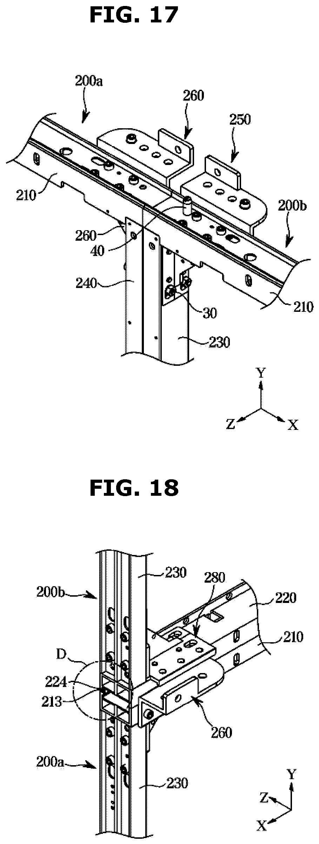

FIG. 16 is an enlarged view of portions of a first cabinet and a second cabinet before being coupled to each other in a display apparatus according to an embodiment. FIG. 17 is a view illustrating the appearance of the first cabinet and the second cabinet shown in FIG. 16 after being coupled to each other.

Referring to FIGS. 16 and 17, a method of removing a seam in the upper-lower direction Y between cabinets 200a and 200b will be described.

Referring to FIG. 16, the fourth frame 240 and the third frame 230 may include adjustment holes 242 and 232 for adjusting a seam in the upper-lower direction Y. The adjustment holes 242 and 232 may each have an extra length in the upper-lower direction Y for adjusting a seam in the upper-lower direction Y. That is, the length in the upper-lower direction Y of the adjustment holes 242 and 232 may be provided longer than the length in front-rear direction Z of the adjustment holes 242 and 232. In other words, the adjustment holes 242 and 232 may be provided without a tolerance in the front-rear direction Z while having a tolerance in the upper-lower direction Y.

Due to the characteristics of extrusion molding and punching, the fastening holes and adjustment holes formed in the frames 210, 220, 230, and 240 may be formed in predetermined positions without substantial errors. However, tolerance may occur during the process of cutting or assembling the frames 210, 220, 230, and 240, which may result in a seam in the left-right direction X, upper-lower direction Y, and front-rear direction Z.

In the first cabinet 200a and the second cabinet 200b that are connected in the left- right direction, the first cabinet 200a and the second cabinet 200b may be positioned such that upper ends of the first cabinet 200a and the second cabinet 200b form a straight line to prevent a seam in the upper-lower direction Y from occurring.

Even when the first cabinet 200a and the second cabinet 200b are positioned such that there is no step in the upper-lower direction X, the adjustment holes 242 and 261b of the first cabinet 200a may be spaced apart from the adjustment holes 251b and 232 of the second cabinet 200b in the left-right direction X due to the assembly tolerance and the tolerance that occurs when cutting the frame. As described above, since the adjustment holes 242, 261b, 251b, and 232 have an extra length in the upper-lower direction Y, the adjustment holes 242 and 261b of the first cabinet 200a and the adjustment holes 251b and 232 of the second cabinet 200b may be coupled by the fastening member 30 even when spaced apart from each other in the upper-lower direction Y. Such a structure may prevent a step in the upper-lower direction Y from occurring when the first cabinet 200a and the second cabinet 200b are coupled. In other words, a seamless in the upper-lower direction Y may be implemented.

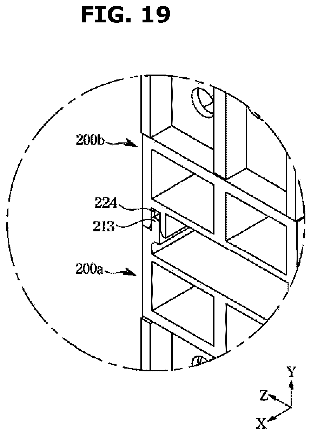

FIG. 18 is a view illustrating portions of a first cabinet and a second cabinet arranged in an upper-lower direction in a display apparatus according to an embodiment. FIG. 19 is an enlarged view of portion D of FIG. 18.

Referring to FIG. 18 and FIG. 19, a seam in the front-rear direction Z of the first cabinet 200a and the second cabinet 200b may be removed using a protrusion and a groove.

Specifically, the first frame 210 of the first cabinet 200a may include a coupling protrusion 213 protruding upward. The second frame 220 of the second cabinet 200 may include a coupling groove 224 into which the coupling protrusion 213 is inserted.

Due to the characteristics of extrusion molding, the first frame 210 and the second frame 220 may be manufactured without substantial errors in the coupling protrusion 213 of the first frame 210 and the coupling groove 224 of the second frame 220. The coupling groove 224 and the coupling protrusion 213 may be provided with substantially the same size to prevent the coupling protrusion 213 inserted into the coupling groove 224 from moving in the front-rear direction Z. Since the coupling protrusion 213within the coupling groove 224 is fixed in the front-rear direction Z, and the coupling groove 224 and the coupling protrusion 213 are manufactured without error, seamlessness in the front-rear direction Z may be implemented.

As described above, the plurality of cabinets 200 according to embodiments may implement seamlessness in the left-right direction X, the upper-lower direction Y, and the front-rear direction Z.

FIG. 20 is a view illustrating an example of a cabinet coupled to an external structure, in a display apparatus according to an embodiment.

Referring to FIG. 20, the cabinet 200 may be directly coupled to an external structure 2 without a separate intermediary using the upper corner bracket 250. More specifically, the cabinet 200 may be coupled to the external structure 2 without a separate intermediary by coupling the horizontal support portion 254 of the upper corner bracket 250 to a horizontal surface 2a of the external structure 2 through the fastening member 30.

In the conventional technology, in order to couple a cabinet to an external structure, such as an external wall or a stand, a separate intermediary coupled to each of the cabinet and the external structure is required. For example, the cabinet is coupled to the external structure using a bracket that is coupled to the cabinet and the external structure. However, the inclusion of the separate intermediary may result in increasing thickness of the display apparatus. In addition, in a process of assembling a plurality of parts, an assembly tolerance occurs , resulting in a seam between the cabinets.

According to one embodiment, the upper corner bracket 250 may be provided to be directly coupled to the external structure 2. The upper corner bracket 250 may include a horizontal support portion 254 that is provided to be coupled to a horizontal surface 2a of the external structure 2. By directly coupling the horizontal support portion 254 to the horizontal surface 2a, the cabinet 200 and a plurality of display modules (not shown) coupled to the cabinet 200 may be coupled to the external structure 2 without a separate intermediary. Since a separate intermediary is not provided, the thickness of the display apparatus may be slimmed down. In addition, by reducing the assembly tolerance, a seamless structure may be implemented.

FIG. 21 is a view illustrating an example of a cabinet being coupled to an external structure, in a display apparatus according to an embodiment.

Referring to FIG. 21, the cabinet 200 may be directly coupled to an external structure 2 without a separate intermediary using the upper corner bracket 250. More specifically, the cabinet 200 may be coupled to the external structure 2 without a separate intermediary by coupling the vertical support portion 255 of the upper corner bracket 250 to a vertical surface 2b of the external structure 2 through the fastening member 30.

The upper corner bracket 250 may be provided to be directly coupled to the external structure 2. The upper corner bracket 250 may include a vertical support portion 255 that is provided to be coupled to a vertical surface 2b of the external structure 2. By directly coupling the vertical support portion 255 to the vertical surface 2b, the cabinet 200 and a plurality of display modules (not shown) coupled to the cabinet 200 may be coupled to the external structure 2 without a separate intermediary.

## Claims

1. A display apparatus (1) comprising:
a display module (100) comprising a substrate and a plurality of light-emitting diodes on the substrate;
a cabinet (200) configured to support the display module such that the display module faces forward; and
a circuit case (300) coupled to the cabinet and configured to accommodate electrical components therein,
wherein the cabinet comprises:
a first frame (210) forming an upper side of the cabinet and comprising a first adjustment hole having an assembly tolerance in a left-right direction,
a second frame (220) forming a lower side of the cabinet and comprising a second adjustment hole having an assembly tolerance in the left-right direction,
a third frame (230) forming a left side of the cabinet and comprising a third adjustment hole having an assembly tolerance in an upper-lower direction,
a fourth frame (240) forming a right side of the cabinet and comprising a fourth adjustment hole having an assembly tolerance in the upper-lower direction,
a first upper corner bracket (250) configured to couple the first frame and the third frame, and
a second upper corner bracket (260) configured to couple the first frame and the fourth frame, **characterized in that**
each of the first upper corner bracket and the second upper corner bracket further comprises a vertical support portion (255) configured to be coupled to a vertical surface of an external structure (2).

2. The display apparatus of claim 1, wherein the cabinet further comprises a first cabinet (200a) and a second cabinet (200b) coupled to the first cabinet in the upper-lower direction, and
the first cabinet and the second cabinet allow seam-adjustment in the left-right direction within a range in which the first adjustment hole (212) of the first cabinet and the second adjustment hole (222) of the second cabinet overlap in the upper-lower direction.

3. The display apparatus of claim 1, wherein the cabinet further comprises a first cabinet (200a) and a second cabinet (200b) coupled to the first cabinet in the left-right direction, and
the first cabinet and the second cabinet allow seam adjustment in the upper-lower direction within a range in which the third adjustment hole (232) of the first cabinet and the fourth adjustment hole (242) of the second cabinet overlap in the left-right direction.

4. The display apparatus of claim 1, wherein the first frame further comprises a coupling protrusion (213) protruding upward from an upper surface of the first frame, and
wherein the second frame further comprises a coupling groove (224) recessed upward from a lower surface of the second frame and configured to accommodate the coupling protrusion.

5. The display apparatus of claim 4, wherein a width of the coupling groove in a front-rear direction and a thickness of the coupling protrusion in the front-rear direction are provided without an assembly tolerance to prevent the coupling protrusion from moving in the front-rear direction within the coupling groove.

6. The display apparatus of claim 5, wherein the cabinet comprises a first cabinet and a second cabinet coupled to the first cabinet in the upper-lower direction, and
wherein in a state in which the coupling protrusion of the first frame is inserted into the coupling groove of the second frame, the first cabinet and the second cabinet are seamless in the front-rear direction.

7. The display apparatus of claim 1, wherein the first upper corner bracket comprises:
a fifth adjustment hole having a size and shape corresponding to the first adjustment hole; and
a sixth adjustment hole having a size and shape corresponding to the third adjustment hole, and
wherein the second upper corner bracket comprises:
a seventh adjustment hole having a size and shape corresponding to the first adjustment hole; and
an eighth adjustment hole having a size and shape corresponding to the fourth adjustment hole.

8. The display apparatus of claim 1, wherein the cabinet further comprises:
a first lower corner bracket (270) configured to couple the second frame and the third frame; and
a second lower corner bracket (280) configured to couple the second frame and the fourth frame.

9. The display apparatus of claim 8, wherein the first lower corner bracket comprises:
a fifth adjustment hole having a size and shape corresponding to the second adjustment hole; and
a sixth adjustment hole having a size and shape corresponding to the third adjustment hole, and
wherein the second lower corner bracket comprises:
a seventh adjustment hole having a size and shape corresponding to the second adjustment hole; and
an eighth adjustment hole having a size and shape corresponding to the fourth adjustment hole.

10. The display apparatus of claim 1, wherein each of the first upper corner bracket and the second upper corner bracket further comprises a horizontal support portion (254) configured to be coupled to a horizontal surface of an external structure (2).

11. The display apparatus of claim 1, wherein an upper end of the third frame is configured to support one side end of the first frame, and
wherein an upper end of the fourth frame is configured to support another side end of the first frame.

12. The display apparatus of claim 1, wherein the first frame, the second frame, the third frame, and the fourth frame are formed by extrusion molding a metal material.

13. The display apparatus of claim 1, wherein the display module comprises a plurality of display modules, and the cabinet is configured to support the plurality of display modules.

## Patentansprüche

1. Anzeigeeinrichtung (1), umfassend:
ein Anzeigemodul (100), das ein Substrat und eine Vielzahl von lichtemittierenden Dioden auf dem Substrat umfasst;
einen Schrank (200), der dazu konfiguriert ist, das Anzeigemodul zu stützen, sodass das Anzeigemodul nach vorne weist; und
ein Schaltungsgehäuse (300), das an den Schrank gekoppelt und dazu konfiguriert ist, elektrische Komponenten darin aufzunehmen,
wobei der Schrank Folgendes umfasst:
einen ersten Rahmen (210), der eine Oberseite des Schranks bildet und ein erstes Einstellloch umfasst, das eine Montagetoleranz in einer Links-Rechts-Richtung aufweist,
einen zweiten Rahmen (220), der eine Unterseite des Schranks bildet und ein zweites Einstellloch umfasst, das eine Montagetoleranz in der Links-Rechts-Richtung aufweist,
einen dritten Rahmen (230), der eine linke Seite des Schranks bildet und ein drittes Einstellloch umfasst, das eine Montagetoleranz in einer Oben-Unten-Richtung aufweist,
einen vierten Rahmen (240), der eine rechte Seite des Schranks bildet und ein viertes Einstellloch umfasst, das eine Montagetoleranz in der Oben-Unten-Richtung aufweist,
eine erste obere Eckhalterung (250), die dazu konfiguriert ist, den ersten Rahmen und den dritten Rahmen zu koppeln, und
eine zweite obere Eckhalterung (260), die dazu konfiguriert ist, den ersten Rahmen und den vierten Rahmen zu koppeln,
**dadurch gekennzeichnet, dass**
jede von der ersten oberen Eckhalterung und der zweiten oberen Eckhalterung ferner einen vertikalen Stützabschnitt (255) umfasst, der dazu konfiguriert ist, an eine vertikale Oberfläche einer externen Struktur (2) gekoppelt zu sein.

2. Anzeigeeinrichtung nach Anspruch 1, wobei der Schrank ferner einen ersten Schrank (200a) und einen zweiten Schrank (200b), der an den ersten Schrank in der Oben-Unten-Richtung gekoppelt ist, umfasst, und
der erste Schrank und der zweite Schrank Nahteinstellung in der Links-Rechts-Richtung innerhalb eines Bereichs ermöglichen, in dem das erste Einstellloch (212) des ersten Schranks und das zweite Einstellloch (222) des zweiten Schranks in der Oben-Unten-Richtung überlappen.

3. Anzeigeeinrichtung nach Anspruch 1, wobei der Schrank ferner einen ersten Schrank (200a) und einen zweiten Schrank (200b), der an den ersten Schrank in der Links-Rechts-Richtung gekoppelt ist, umfasst, und
der erste Schrank und der zweite Schrank Nahteinstellung in der Oben-Unten-Richtung innerhalb eines Bereichs ermöglichen, in dem das dritte Einstellloch (232) des ersten Schranks und das vierte Einstellloch (242) des zweiten Schranks in der Links-Rechts-Richtung überlappen.

4. Anzeigeeinrichtung nach Anspruch 1, wobei der erste Rahmen ferner einen Kopplungsvorsprung (213) umfasst, der von einer oberen Oberfläche des ersten Rahmens nach oben vorspringt, und
wobei der zweite Rahmen ferner eine Kopplungsnut (224) umfasst, die von einer unteren Oberfläche des zweiten Rahmens nach oben vertieft und dazu konfiguriert ist, den Kopplungsvorsprung aufzunehmen.

5. Anzeigeeinrichtung nach Anspruch 4, wobei eine Breite der Kopplungsnut in einer Vorne-Hinten-Richtung und eine Dicke des Kopplungsvorsprungs in der Vorne-Hinten-Richtung ohne eine Montagetoleranz bereitgestellt sind, um zu verhindern, dass sich der Kopplungsvorsprung in der Vorne-Hinten-Richtung innerhalb der Kopplungsnut bewegt.

6. Anzeigeeinrichtung nach Anspruch 5, wobei der Schrank einen ersten Schrank und einen zweiten Schrank, der an den ersten Schrank in der Oben-Unten-Richtung gekoppelt ist, umfasst, und
wobei in einem Zustand, in dem der Kopplungsvorsprung des ersten Rahmens in die Kopplungsnut des zweiten Rahmens eingesetzt ist, der erste Schrank und der zweite Schrank nahtlos in der Vorne-Hinten-Richtung sind.

7. Anzeigeeinrichtung nach Anspruch 1, wobei die erste obere Eckhalterung Folgendes umfasst:
ein fünftes Einstellloch, das eine Größe und Form entsprechend dem ersten Einstellloch aufweist; und
ein sechstes Einstellloch, das eine Größe und Form entsprechend dem dritten Einstellloch aufweist, und
wobei die zweite obere Eckhalterung Folgendes umfasst:
ein siebtes Einstellloch, das eine Größe und Form entsprechend dem ersten Einstellloch aufweist; und
ein achtes Einstellloch, das eine Größe und Form entsprechend dem vierten Einstellloch aufweist.

8. Anzeigeeinrichtung nach Anspruch 1, wobei der Schrank ferner Folgendes umfasst:
eine erste untere Eckhalterung (270), die dazu konfiguriert ist, den zweiten Rahmen und den dritten Rahmen zu koppeln; und
eine zweite untere Eckhalterung (280), die dazu konfiguriert ist, den zweiten Rahmen und den vierten Rahmen zu koppeln.

9. Anzeigeeinrichtung nach Anspruch 8, wobei die erste untere Eckhalterung Folgendes umfasst:
ein fünftes Einstellloch, das eine Größe und Form entsprechend dem zweiten Einstellloch aufweist; und
ein sechstes Einstellloch, das eine Größe und Form entsprechend dem dritten Einstellloch aufweist, und
wobei die zweite untere Eckhalterung Folgendes umfasst:
ein siebtes Einstellloch, das eine Größe und Form entsprechend dem zweiten Einstellloch aufweist; und
ein achtes Einstellloch, das eine Größe und Form entsprechend dem vierten Einstellloch aufweist.

10. Anzeigeeinrichtung nach Anspruch 1, wobei jede von der ersten oberen Eckhalterung und der zweiten oberen Eckhalterung ferner einen horizontalen Stützabschnitt (254) umfasst, der dazu konfiguriert ist, an eine horizontale Oberfläche einer externen Struktur (2) gekoppelt zu sein.

11. Anzeigeeinrichtung nach Anspruch 1, wobei ein oberes Ende des dritten Rahmens dazu konfiguriert ist, ein Seitenende des ersten Rahmens zu stützen, und
wobei ein oberes Ende des vierten Rahmens dazu konfiguriert ist, ein anderes Seitenende des ersten Rahmens zu stützen.

12. Anzeigeeinrichtung nach Anspruch 1, wobei der erste Rahmen, der zweite Rahmen, der dritte Rahmen und der vierte Rahmen durch Strangpressen eines Metallmaterials gebildet sind.

13. Anzeigeeinrichtung nach Anspruch 1, wobei das Anzeigemodul eine Vielzahl von Anzeigemodulen umfasst und der Schrank dazu konfiguriert ist, die Vielzahl von Anzeigemodulen zu stützen.

## Revendications

1. Appareil d'affichage (1) comprenant :
un module d'affichage (100) comprenant un substrat et une pluralité de diodes électroluminescentes sur le substrat ;
un boîtier (200) configuré pour supporter le module d'affichage de sorte que le module d'affichage soit tourné vers l'avant ; et
un logement de circuit (300) couplé au boîtier et conçu pour recevoir des composants électriques dans celui-ci,
dans lequel le boîtier comprend :
un premier cadre (210) formant un côté supérieur du boîtier et comprenant un premier trou de réglage ayant une tolérance d'assemblage dans une direction gauche-droite,
un deuxième cadre (220) formant un côté inférieur du boîtier et comprenant un deuxième trou de réglage ayant une tolérance d'assemblage dans la direction gauche-droite,
un troisième cadre (230) formant un côté gauche du boîtier et comprenant un troisième trou de réglage ayant une tolérance d'assemblage dans une direction haut-bas,
un quatrième cadre (240) formant un côté droit du boîtier et comprenant un quatrième trou de réglage ayant une tolérance d'assemblage dans la direction haut-bas,
un premier support de coin supérieur (250) configuré pour coupler le premier cadre et le troisième cadre, et
un deuxième support de coin supérieur (260) configuré pour coupler le premier cadre et le quatrième cadre,
**caractérisé en ce que** chacun du premier support de coin supérieur et du deuxième support de coin supérieur comprend en outre une partie de soutien verticale (255) conçue pour être couplée à une surface verticale d'une structure externe (2).

2. Appareil d'affichage selon la revendication 1, dans lequel le boîtier comprend en outre un premier boîtier (200a) et un second boîtier (200b) couplé au premier boîtier dans le sens haut-bas, et
le premier boîtier et le second boîtier permettent un réglage d'alignement dans la direction gauche-droite dans une plage dans laquelle le premier trou de réglage (212) du premier boîtier et le deuxième trou de réglage (222) du second boîtier se chevauchent dans la direction haut-bas.

3. Appareil d'affichage selon la revendication 1, dans lequel le boîtier comprend en outre un premier boîtier (200a) et un second boîtier (200b) couplé au premier boîtier dans la direction gauche-droite, et
le premier boîtier et le second boîtier permettent un réglage d'alignement dans la direction haut-bas dans une plage dans laquelle le troisième trou de réglage (232) du premier boîtier et le quatrième trou de réglage (242) du second boîtier se chevauchent dans la direction gauche-droite.

4. Appareil d'affichage selon la revendication 1, dans lequel le premier cadre comprend en outre une saillie de couplage (213) faisant saillie vers le haut à partir d'une surface supérieure du premier cadre, et
dans lequel le deuxième cadre comprend en outre une rainure de couplage (224) en retrait vers le haut à partir d'une surface inférieure du deuxième cadre et configurée pour recevoir la saillie de couplage.

5. Appareil d'affichage selon la revendication 4, dans lequel une largeur de la rainure de couplage dans une direction avant-arrière et une épaisseur de la saillie de couplage dans la direction avant-arrière sont prévues sans tolérance d'assemblage pour empêcher la saillie de couplage de se déplacer dans la direction avant-arrière à l'intérieur de la rainure de couplage.

6. Appareil d'affichage selon la revendication 5, dans lequel le boîtier comprend un premier boîtier et un second boîtier couplé au premier boîtier dans le sens haut-bas, et
dans lequel dans un état dans lequel la saillie de couplage du premier cadre est insérée dans la rainure de couplage du deuxième cadre, le premier boîtier et le second boîtier sont sans joint visible dans la direction avant-arrière.

7. Appareil d'affichage selon la revendication 1, dans lequel le premier support de coin supérieur comprend :
un cinquième trou de réglage présentant une taille et une forme correspondant au premier trou de réglage ; et
un sixième trou de réglage présentant une taille et une forme correspondant au troisième trou de réglage, et
dans lequel le deuxième support de coin supérieur comprend :
un septième trou de réglage présentant une taille et une forme correspondant au premier trou de réglage ; et
un huitième trou de réglage présentant une taille et une forme correspondant au quatrième trou de réglage.

8. Appareil d'affichage selon la revendication 1, dans lequel le boîtier comprend en outre :
un premier support de coin inférieur (270) configuré pour coupler le deuxième cadre et le troisième cadre ; et
un deuxième support de coin inférieur (280) configuré pour coupler le deuxième cadre et le quatrième cadre.

9. Appareil d'affichage selon la revendication 8, dans lequel le premier support de coin inférieur comprend :
un cinquième trou de réglage présentant une taille et une forme correspondant au deuxième trou de réglage ; et
un sixième trou de réglage présentant une taille et une forme correspondant au troisième trou de réglage, et
dans lequel le deuxième support de coin inférieur comprend :
un septième trou de réglage présentant une taille et une forme correspondant au deuxième trou de réglage ; et
un huitième trou de réglage présentant une taille et une forme correspondant au quatrième trou de réglage.

10. Appareil d'affichage selon la revendication 1, dans lequel chacun du premier support de coin supérieur et du deuxième support de coin supérieur comprend en outre une partie de soutien horizontale (254) conçue pour être couplée à une surface horizontale d'une structure externe (2).

11. Appareil d'affichage selon la revendication 1, dans lequel une extrémité supérieure du troisième cadre est configurée pour supporter une extrémité latérale du premier cadre, et
dans lequel une extrémité supérieure du quatrième cadre est configurée pour supporter une autre extrémité latérale du premier cadre.

12. Appareil d'affichage selon la revendication 1, dans lequel le premier cadre, le deuxième cadre, le troisième cadre et le quatrième cadre sont formés par moulage par extrusion d'un matériau métallique.

13. Appareil d'affichage selon la revendication 1, dans lequel le module d'affichage comprend une pluralité de modules d'affichage, et le boîtier est configuré pour supporter la pluralité de modules d'affichage.
